Europäisches Patentamt

European Patent Office

Office européen des brevets

(11) Publication number: **0 652 444 A1**

# EUROPEAN PATENT APPLICATION

(21) Application number: 94117602.6

(22) Date of filing: 08.11.94

(51) Int. Cl.6: **G01R 31/307**

(30) Priority: 08.11.93 JP 278517/93
01.12.93 JP 301618/93

(43) Date of publication of application:
**10.05.95 Bulletin 95/19**

(84) Designated Contracting States:
**DE GB**

(71) Applicant: **ADVANTEST CORPORATION**
32-1, Asahicho 1-chome
Nerima-Ku,
Tokyo 176 (JP)

(72) Inventor: **Goishi, Akira**
15-10, Minamicho
Kazo-shi,
Saitama (JP)
Inventor: **Kuribara, Masayuki**
368-1, Ohaza Shimonakajo
Gyoda-shi,
Saitama (JP)
Inventor: **Iwai, Toshimichi**
Wakakodamaryo 208, 3063, Wakakodama
Gyoda-shi,
Saitama (JP)
Inventor: **Kawamoto, Hiroshi**
2-77-11, Menumahigashi,
Menumamachi
Ohsato-gun,
Saitama (JP)

(74) Representative: **Hoffmann, Eckart, Dipl.-Ing.**
**Patentanwalt**
**Bahnhofstrasse 103**
**D-82166 Gräfelfing (DE)**

(54) Method and apparatus for forming a potential distribution image of a semiconductor integrated circuit.

(57) A trigger signal generator which repeatedly generates a sequence of test patterns and generates a trigger signal in synchronization with a desired test pattern in each repetition of the sequence of test patterns, a delayed pulse generator which responds to the trigger signal to generate a charged particle beam drive pulse delayed by a desired time interval behind the trigger signal, a charged particle beam irradiation device which responds to the delayed pulse to irradiate an IC under test with a charged particle beam pulse and detects the amount of secondary electron emission from the irradiated point, and a control part which causes image data of a predetermined frame to be captured upon receiving from a test signal generator a condition signal which designates an IC drive condition, are provided. Upon completion of capturing the image data of the predetermined frame, the control part sends an acquisition completion signal to the test signal generator, which changes the IC drive condition and generates a drive signal.

FIG. 2

BACKGROUND OF THE INVENTION

The present invention relates to a method and apparatus for forming a potential distribution image of a semiconductor integrated circuit (hereinafter referred to simply as an IC) and, more particularly, to an IC potential distribution image forming method which irradiates an IC with an electron beam, ion beam or similar charged particle beam, measures the amount of secondary electron emission from the IC and displays the potential distribution of the IC as a gray-scale image which is used, for example, to pinpoint faulty components of the IC. The invention also pertains to an apparatus using the IC potential distribution image forming method.

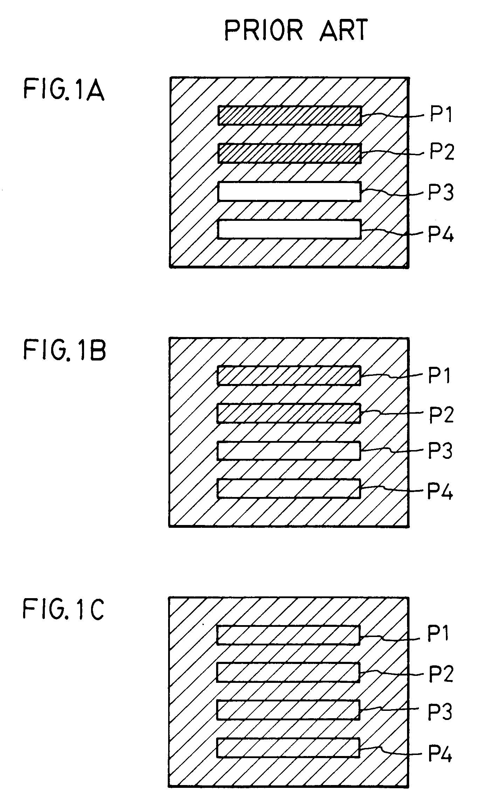

In an IC tester which tests an IC through the sequential application thereto of a predetermined sequence of test patterns from a pattern generator, it is customary in the prior art to obtain, with an electron beam tester by the procedure such as mentioned below, a secondary electron emission image on the surface of the IC in its operative state under desired drive conditions (such as a test pattern sequence, a particular test pattern, the pattern phase, the test cycle period and the power supply voltage). That is, circulation of a predetermined sequence of test patterns is halted at the time of generation of a desired test pattern, a desired area of the IC made operative by the application of the fixed test pattern is scanned with an electron beam spot, the amount of secondary electron emission at each irradiated spot is measured and used as pixel data to thereby display a gray-scale image corresponding to the amount of secondary electron emission from the respective area irradiated with the electron beam. In this instance, IC conductor pattern images P1 through P4 such as shown in Fig. 1A are displayed. The amount of secondary electron emission from the conductor supplied with a high potential is small; the corresponding image is displayed dark like the pattern images P1 and P2. On the other hand, the amount of secondary electron emission from the conductor supplied with a low potential is large; the resulting image is displayed bright like the pattern images P3 and P4. The part 15 other than the conductors is displayed gray since the amount of secondary electron emission from such a part is intermediate between the amounts of secondary electron emission from the conductors supplied with the high and low potentials.

Since the applied test pattern corresponding to this display image is preknown, that is, since the potential of each conductor in its normal state is preknown, it is possible to judge from the display image whether the IC is normal or which part of the IC is defective. It is extremely difficult, however, to locate minute imperfections in a complicated secondary electron image of a highly integrated electronic circuit.

A common practice of improving the SN ratio of image data is, for example, to average image data repeatedly obtained from the same area of the IC. This processing involves forming the secondary electron emission image a plurality of times through repetitive scanning of the same IC surface area. However, the IC chip is usually coated over the entire area of its surface with a protective insulating layer and as the electron beam irradiation of the same surface area of the IC is repeated using the same test pattern so as to obtain the same image over and over again, the protective coating is charged so that the potential distribution becomes uniform all over it with respect to the potential of the applied test pattern, providing no potential difference over the IC surface. In consequence, as shown in Fig. 1B, the high-level conductor pattern images P1 and P2 become lighter and the low-level conductor pattern images P3 and P4 become whitish-gray, making it difficult to detect the potential distribution over the entire area of the IC surface; eventually, the potential is distributed uniformly all over the IC surface, and as shown in Fig. 1C, the display image turns gray almost all over it, making it impossible to detect the potential distribution.

Since the response of the IC to the test pattern applied thereto varies depending on a delay and transient characteristic, there are cases where it is desirable to observe, through a secondary electron emission image, the operative state of a desired area on the IC a desired elapsed time after the application of the test pattern. Such a secondary electron emission image (hereinafter referred to as a strobo image) could be obtained by repeatedly measuring the amount of secondary electron emission from the electron-beam bombarded point on the IC at desired timing relative to the timing of generation of a desired pattern in a sequence of test patterns which are repetitively generated while shifting the electron beam by one pixel distance upon each generation of the desired pattern. Also in this instance, it is difficult to locate failing parts in the secondary electron emission image, and when the secondary electron image of the same area is repeatedly obtained under the same IC drive condition, the contrast of the image gradually lowers, making it impossible to discriminate images of individual IC components as referred to above. This problem is also presented in the case where changes in the IC operative conditions at regular time intervals after the generation of a desired test pattern are displayed as one image (hereinafter referred to as a logic state mapping image or simply as an LSM image).

Furthermore, in an IC wherein pluralities of sequential circuits and logic circuits are connected in cascade, it is necessary to obtain a number of images to detect the failure occurrence timing in the test signal.

## SUMMARY OF THE INVENTION

It is therefore an object of the present invention to provide a semiconductor IC potential distribution image forming method and apparatus which permits repetitive formation of a high-contrast secondary electron emission strobo image showing the operative state of an IC a desired elapsed time after the application thereto of a desired test pattern and hence facilitates the location of faulty components in the Ic.

Another object of the present invention is to provide an IC potential distribution forming method and apparatus which permits repetitive formation of a high-contrast secondary electron emission LSM image showing changes in the operative state of an IC at predetermined time intervals after the application thereto of a desired test pattern.

According to the present invention, a semiconductor IC in a charged particle beam irradiation device is driven by a drive signal containing repetition of a sequence of test patterns and is irradiated with a charged particle beam and the secondary electron emission from the irradiated area of the IC is measured to obtain an IC potential distribution image.

According to a first aspect of the present invention, the semiconductor IC in the charged particle beam irradiation device is driven by the above-mentioned drive signal under the drive condition specified by a condition signal indicating one of a plurality of predetermined drive conditions, then a delay pulse which is delayed for a desired period of time behind the generation of a desired test pattern in each repetition of the above-mentioned sequence of test patterns is generated by delay pulse generating means and a charged particle beam pulse is generated by the charged particle beam irradiation device in response to the delay pulse. In response to the applied condition signal, the semiconductor held in operation is irradiated with the charged particle beam while scanning it over a desired area and the amount of secondary electron emission from each irradiated point is detected and obtained as image data corresponding to each pixel; this operation is repeated and the image data thus obtained is stored in memory means in correspondence with the specified IC drive condition. Similar image data is stored in the memory means for each different drive condition. Then, the pieces of image data thus stored in the memory means in correspondence with the individual drive conditions are processed and displayed.

According to a second aspect of the present invention, the drive signal is applied to the semiconductor IC in the charged particle irradiation device to drive the IC, then a delay pulse which is delayed for a predetermined period of time behind the generation of a desired test pattern in each repetition of the above-mentioned sequence of test patterns is generated by pulse generating means and a charged particle beam pulse is generated by the charged particle beam irradiation device in response to the delay pulse. The semiconductor IC held in operation is irradiated with the charged particle beam pulse while scanning it over a desired area and the amount of secondary electron emission from each irradiated point and obtained as image data corresponding to each pixel; this operation is repeated and the image data thus obtained is stored in memory means in correspondence with the above-said predetermined delay time. Similar image data is stored in the memory means for each different delay time. Then, the pieces of image data thus stored in the memory in correspondence with the respective delay times are processed and delayed.

According to a third aspect of the present invention, the drive signal is applied to the semiconductor IC in the charged particle beam irradiation device to drive the IC, then a plurality of delay pulses which are delayed for different periods of time behind the generation of a desired test pattern in each repetition of the above-said sequence of test patterns are generated by pulse generating means and a charged particle beam pulse is generated by the charged particle beam irradiation device a plurality of times in response to the plurality of delay pulses. The semiconductor IC held in operation is irradiated with the charged particle beam pulse while scanning it a plurality of times at the same point and the amounts of secondary electron emission from the repeatedly irradiated point are detected and obtained as a plurality of pieces of image data corresponding to the above-said different delay times; this operation is repeated and the pieces of image data thus obtained are stored in memory means in correspondence with the different delay times. Upon completion of storing the image data of one frame in the memory means for every delay time, the pieces of image data stored corresponding to the respective delay times are processed and displayed.

According to a fourth aspect of the present invention, the semiconductor IC in the charged particle beam irradiation device is driven by the drive signal under the drive condition specified by a condition signal indicating one of a plurality of predetermined drive conditions, then a trigger signal which is provided in synchronization with the generation of a desired test pattern in each repetition of the sequence of test patterns is delayed corresponding to the position of one point of scanning by the charged particle beam on either one of horizontal and vertical scanning lines covering a predetermined area of the semiconductor IC to generate a delay pulse by pulse generating means and a charge particle beam pulse is generated by the charged particle beam irradiation device in response to the delay pulse. The semiconductor IC held in operation is irradiated with the charged particle beam pulse at the above-mentioned one scanning point in the above-said predetermined area of the IC surface and the amount of secondary electron emission from the irradiated point is detected and obtained as image data corresponding to each pixel; this operation is repeated and the resulting image data is stored in memory means in correspondence with the specified drive condition. Similar image data is stored in the memory means for each different drive condition. The pieces of image data thus stored in the memory means in correspondence with the respective drive conditions are processed and displayed.

According to a fifth aspect of the present invention, the semiconductor IC in the charged particle beam irradiation device is driven by the drive signal under the drive condition specified by a condition signal indicating one of a plurality of predetermined IC drive conditions, then a trigger signal which is provided by test signal generating means in synchronization with the generation of a desired test pattern in each repetition of the sequence of test patterns is delayed corresponding to respective points of scanning by the charged particle beam on either one of horizontal and vertical scanning lines covering a predetermined area of the semiconductor IC to generate delay pulses respectively corresponding to the above-mentioned scanning points by pulse generating means in a sequential order, and charged particle beam pulses corresponding to the scanning points on one scanning line are generated by the charged particle beam irradiation device in response to the above-mentioned delay pulses. The semiconductor IC held in operation is irradiated with the charged particle beam pulses at the corresponding scanning points in the above-said predetermined area of the IC surface, and the amounts of secondary electron emission from the irradiated points are sequentially detected and obtained as image data corresponding to one scanning line; this operation is repeated and the image data is stored in memory means in correspondence with the specified drive condition. Similar image data is stored in the memory means for each different drive condition. The pieces of image data thus stored in the memory means in correspondence with the respective IC drive conditions are processed and displayed.

BRIEF DESCRIPTION OF THE DRAWINGS

Fig. 1 shows a series of diagrams for explaining problems presented in the prior art;
Fig. 2 is a block diagram illustrating an embodiment of the present invention;
Fig. 3 is a timing chart showing, by way of example, the relationships among a test pattern signal, a trigger signal and an irradiation pulse;
Fig. 4A is a flowchart showing an example of the operation of a test signal generator 12;
Fig. 4B is a flowchart showing an example of the operation of an electron beam tester;
Fig. 5 shows a series of diagrams illustrating examples of secondary electron emission images;
Fig. 6 is a timing chart showing another example of the relationships among the test pattern signal, the trigger signal and the irradiation pulse;
Fig. 7 is a flowchart showing another example of the operation of the electron beam tester;
Fig. 8 is a block diagram illustrating a second embodiment of the present invention;
Fig. 9 is a timing chart for explaining the formation of an LSM image in the Fig. 8 embodiment;
Fig. 10 is a diagram showing the relationship between a scanning line and a delay time in the case of obtaining an LSM image, using the horizontal-axis direction as the time axis of the operation of an IC;
Fig. 11A is a diagram showing examples of signals on conductors under the IC drive condition where the IC operation is normal;
Fig. 11B is a diagram showing examples of signals on conductors under the IC drive condition where the IC operation is abnormal;
Fig. 11C is a diagram showing an example of the display of image data obtained in the case of Fig. 11A;
Fig. 11D is a diagram showing an example of the display of image data obtained in the case of Fig. 11B;
Fig. 11E is a diagram showing an example of the display of a difference image between the image data in the cases of Figs. 11C and 11D;
Fig. 12A is a diagram showing a normal signal and various abnormal signals on the same conductor;
Fig. 12B is a diagram showing a display image corresponding to each abnormal signal in Fig. 12A;
Fig. 13 is a diagram showing the relationship between the scanning line and the delay time in the case of obtaining an LSM image, using the vertical-axis direction as the time axis of the operation of the IC;

Fig. 14 is a block diagram illustrating an example of random scanning signal generating means and the corresponding delay circuit 22; and

Fig. 15 is a timing chart for explaining the formation of an LSM image in another mode of operation in the Fig. 8 embodiment.

## DESCRIPTION OF THE PREFERRED EMBODIMENTS

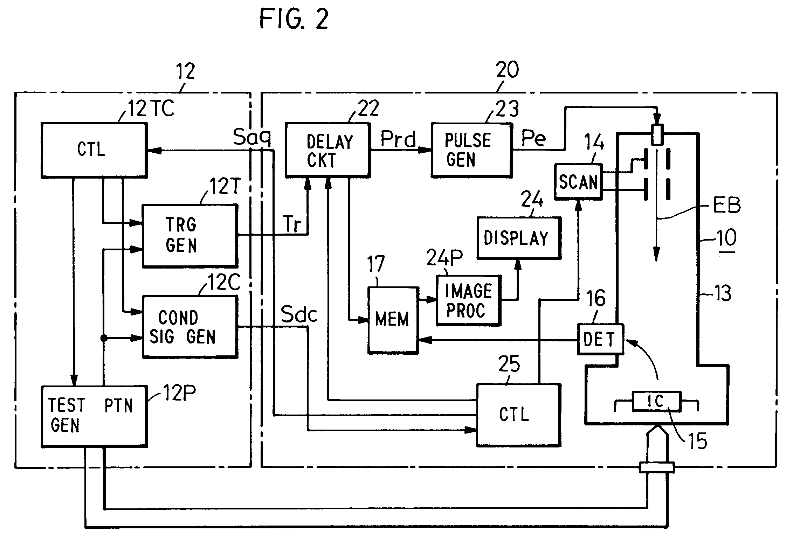

In Fig. 2 there is illustrated an embodiment of the present invention. A charged particle beam tester 20 has an electron beam irradiation device as a charged particle beam irradiation device 10, and hence is shown to be constructed as an electron beam irradiation device. A test signal generator 12, which constitutes part of an IC tester, is connected to the charged particle or electron beam tester 20. In the electron beam tester 20, an electron beam EB is generated in a pulse form in a vacuum chamber 13 and is directed to an IC 15 placed therein. Secondary electrons resulting from the bombardment of the IC 15 with the electron beam EB are detected by a secondary electron detector 16 and the amount of secondary electron emission detected is stored in a memory 21.

The IC 15 is supplied with a power source voltage set for testing it, while at the same time a sequence of test pattern signals, which are repeatedly generated by a test pattern generating part 12P in the test signal generator 12, are applied to the IC 15 to drive it. The power supply voltage and the sequence of test pattern signals form a drive signal. A trigger signal Tr is generated by a trigger signal generating part 12T in synchronization with a desired test pattern signal in each repetition of the sequence of test pattern signals and is provided to a delay circuit 22 in the electron beam tester 20. The trigger signal Tr is delayed by the delay circuit 22 for a desired period of time $\Delta T$ set by a control part 25 and is then outputted as a delayed pulse Trd. A pulse generator 23 responds to the delayed pulse Trd to generate a pulse Pe, which is provided to the electron beam irradiation device 10, wherein the electron beam EB is applied pulsewise to the surface of the IC 15 at the position specified by a scanning part 14. As a result, secondary electrons are observed which are emitted from the electron-beam irradiated spot (corresponding to one pixel) at the specified position on the IC 15 in its electrically operative state when the delay time $\Delta T$ set by the delay circuit 22 has elapsed since the application of the desired test pattern to the IC 15. The control part 25 presets the desired scanning area in the scanning part 14 and responds to a condition signal Sdc from a condition signal generating part 12C to start the scanning of the IC surface by the electron beam EB and the storing of image data into the memory 17.

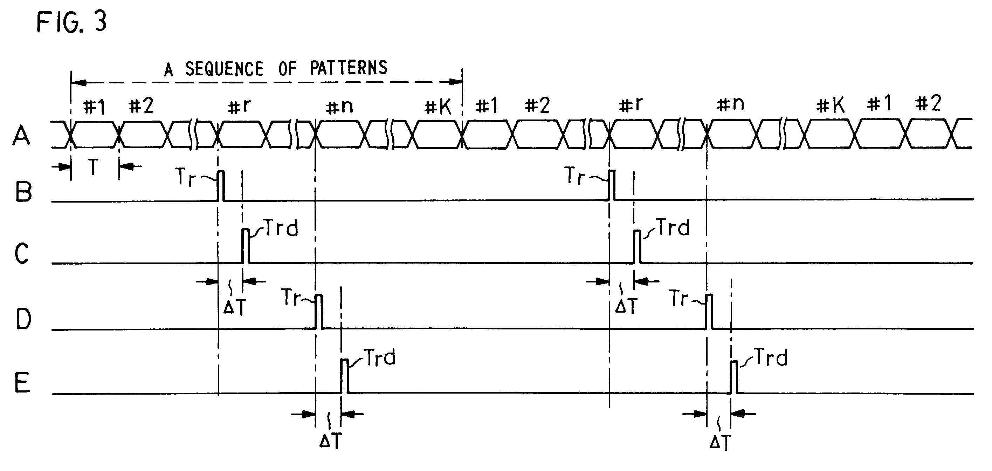

Various test patterns, such as a pattern of writing a "1" and at specified timing in a test cycle T, a pattern of writing a "0" at specified timing in the test cycle T and a high impedance input pattern, are repeatedly generated as a sequence of test patterns #1 through #K in a predetermined sequence. The IC 15 usually has a number of input terminal pins, to which a sequence of predetermined test patterns are provided in parallel. In Fig. 3-Row A there are shown, as a repetition of one test pattern sequence, the test patterns that are provided to the input terminal pins of the IC 15 in parallel; in the following description, the plurality of sequences of test patterns that are provided in parallel as a whole will be referred to simply as a sequence of test patterns.

A desired pattern in the sequence of test patterns #1 through #K, which are generated by the test pattern generating part 12P, can be specified by using numbers #1, #2, ..., "K assigned to the patterns in order of generation (also referred to as pattern addresses). In synchronization with the generation of a specified a one of the test patterns, for example, the pattern #r, the trigger signal Tr is generated by the trigger signal generating part 12T as shown in Fig. 3-Row B. The trigger signal Tr is delayed by the time interval $\Delta T$ in the delay circuit 22 as shown in Fig. 3-Row C, from which it is outputted as the delayed pulse Trd. The pulse generator 23 responds to the delayed pulse Trd to generate the electron beam drive pulse Pe, which is supplied to the electron beam irradiation device 10, wherein the electron beam EB is applied pulsewise to the IC 15.

In this way, the electron beam EB is applied pulse-wise to the IC 15 at the timing specified on the basis of the timing of generation of the test pattern #r, and as a result, secondary electrons emitted from the irradiated point on the IC 15 are measured by the secondary electron detector 16 and data of one pixel is stored in the memory 17. Likewise, at the timing similarly delayed on the basis of the timing of the trigger signal Tr synchronized with the generation of the same pattern #r in the next sequence of test patterns, the electron beam EB is applied to the IC 15 at a point adjacent to the previously irradiated point (corresponding to the adjacent pixel) and image data by secondary electrons emitted from the newly irradiated point is written into the memory 17. Thereafter the same operation is repeated, by which data of one frame on the surface area of the IC 15 specified by the control part 25 is obtained in the memory 17. The data thus stored in the memory 17 is processed in an image processing part 24P and is displayed as an image on a display 24. The display image shows the operative state of an electronic circuit in the scanned surface area of the IC 15 at the point when the time $\Delta T$ has elapsed since the application of the specified test pattern #r to the IC 15. The display image will hereinafter be referred to as a strobo image.

Furthermore, in one mode of operation in this embodiment, a secondary electron strobo image in the case of the IC 15 being given a drive condition for normal operation and a secondary electron strobo image in the case of the IC 15 being given a drive condition for abnormal operation are displayed alternately with each other. The drive condition is any one of the test pattern to be applied to the IC 15, the power supply voltage, the test cycle period T (i.e. the operation clock period), the pattern phase and the pattern sequence, or a desired combination of them. Each time the drive condition is given, the writing of image data into the memory 17 begins. That is, the condition signal generating part 12C outputs, in a predetermined sequence, condition signals Sdc each specifying one of a plurality of predetermined drive conditions for the IC 15. Upon each application of such a condition signal Sdc, the control part 25 causes the acquisition of the secondary electron emission image data into the memory 17 to start and, upon completion of the acquisition of one-frame image, generates and applies an acquisition completion signal Saq to the test signal generator 12. Upon receiving the acquisition completion signal Saq, the test signal generator 12 proceeds to the test under the next drive condition.

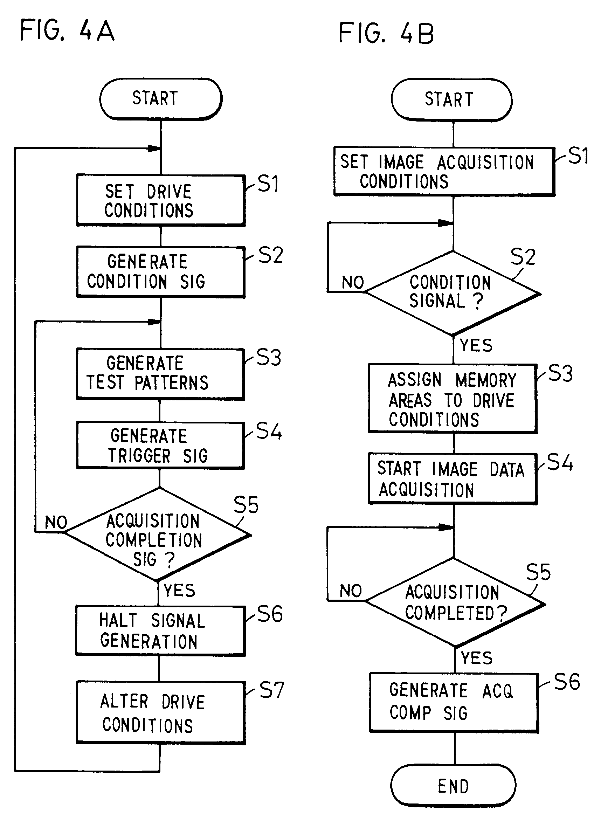

In Fig. 4A there is shown the flow of operation by the test signal generator 12. The operation starts with setting the IC drive conditions (a combination of desired conditions such as the test pattern, the pattern phase, the pattern sequence, the test cycle period and the power supply voltage) which are specified according to the secondary electron image of the IC desired to obtain (step S1). The condition signal Sdc, which specifies these drive conditions, is generated by the condition signal generating part 12C and is applied to the control part 25 of the electron beam test equipment 20 (step S2). Then, the test pattern generating part 12P starts to generate a sequence of test patterns, which are sent to the IC 15 in the chamber 13 (step S3). At the timing of generation of a specified pattern, the trigger signal Tr is generated by the trigger signal generating part 12T and is provided to the electron beam test equipment 20 (step S4). This is followed by making a check to see if the acquisition completion signal Saq has been received. If not, the process goes back to step S3 at the end of the sequence of test patterns; the same sequence of test patterns are generated again and the same operations are repeated.

Upon receiving the acquisition completion signal Saq in step S5, a control part 12TC causes the test pattern generating part 12P to halt the generation of the test pattern signal (step S6), changes the drive conditions by one step in a predetermined order (step S7) and returns to step S1, in which the changed drive conditions are set and the conditions signal Sdc and the test pattern signal are generated in the same manner as in the above. In Fig. 3-Rows D and E there are shown examples of such changed drive conditions; the test pattern on the basis of which the trigger signal Tr is generated is identified by #n and the pulse Trd is produced which is delayed the time interval $\Delta T$ behind the trigger signal Tr as described above. In the electron beam tester 20, the secondary electron strobo image of the IC 15 under the changed drive condition is acquired or formed.

The flow of operation by the electron beam tester 20 is shown in Fig. 4B. The operation begins with setting image capturing conditions such as the electron beam scanning speed, the area to be scanned, the electron beam acceleration and the position of scanning (step S1). Then, the electron beam tester waits for the transmission of the condition signal Sdc from the test signal generator 12 to the control part 25 (S2). Upon receipt of the condition signal Sdc, the control part 25 interprets its contents, sets the area of the memory 17 into which the image data is loaded (S3), and starts the image loading (S4). In other words, upon each reception of the delayed trigger signal Trd, image data of one pixel is acquired as described previously. A check is repeatedly made to see if the loading of image data of one frame has been completed (S5), and if so, the control part 25 generates and applies the acquisition completion signal Saq to the test signal generator 12 (S6).

By providing a display of image data corresponding to, for example, the difference between the secondary-emission image data obtained under the normal-operation drive condition and the secondary-emission image data obtained under the abnormal-operation drive condition, faulty parts or components could easily be located. In practice, to increase the SN ratio of the image data, the image capturing operations under the two different drive conditions are alternately repeated M times (where M is an integer equal to or greater than 2, for example, in the range of between 5 and 10) and the image data obtained for each drive condition is accumulated (image data averaging process). Then, the image data of the difference between these pieces of image data of high SN ratios thus obtained for the two different drive conditions is displayed as a strobo image. In another mode of operation, pieces of image data for two different patterns in a sequence of test patterns are alternately acquired a plurality of times, by which an averaged secondary electron strobo image is obtained for each test pattern. In this instance, the potential varies even in the same electronic circuit area on the IC 15; in particular, when the potential varies with a change in the logical value, the potential variation can be displayed as a high-contrast image free from the influence of the charging of the IC protective coating.

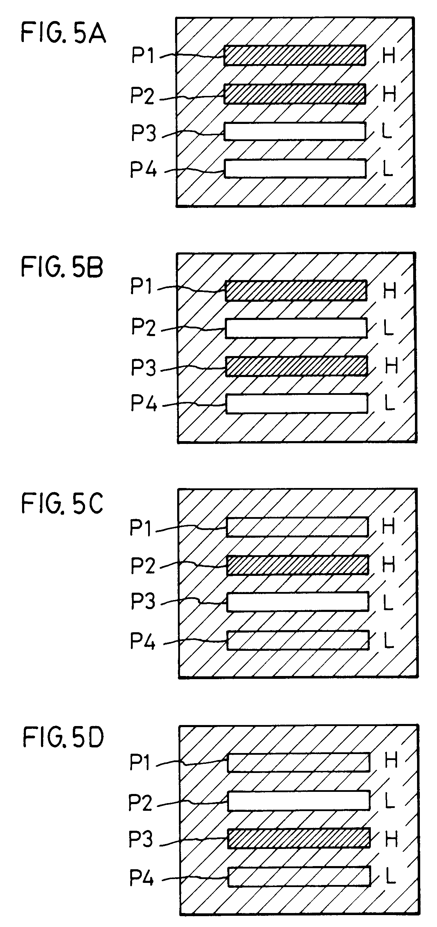

Now, let it be assumed that images shown in Fig. 5A are obtained under a certain drive condition in the initial state in which the IC protective coating is not ever charged and that, as shown in Fig. 5B, when the drive condition is changed, the conductor pattern images P1 and P4 do not undergo any potential variations and hence remain identical with those in Fig. 5A but the conductor pattern images P2 and P3 vary from the high to low potential and from the low to high potential, respectively. It will be seen that as the images are repeatedly captured alternately under the two drive conditions, the conductor pattern images P2 and P3 corresponding to those obtained under the drive conditions in Fig. 5A are clearly displayed as depicted in Fig. 5C; that is, the former is high-potential and the latter low-potential. It will be understood that the conductor pattern images P1 and P4 become gray, and hence have not undergone any potential variations. Similarly, when the images are captured under the same drive condition as in Fig. 5B, the conductor pattern image P2 is clearly displayed white and the conductor pattern image P3 black as shown in Fig. 5D. Thus, by implementing the alternate driving of the IC under two different conditions (different test patterns, for example), it is possible to suppress the charging of the IC protective coating and hence obtain high-contrast secondary electron emission images.

In the above the acquisition completion signal Saq is sent to the test signal generator 12 upon capturing one frame of image data in the electron beam tester 20, but instead of this, it is possible to change the drive condition in the test signal generator 12 upon each conclusion of a predetermined time long enough to allow the acquisition of the one-frame data in the electron beam tester 20. In such an instance, instead of waiting for the reception of the acquisition completion signal Saq in step S5 shown in Fig. 4A, a check is made to see if the predetermined time has elapsed and if not, the generation of the test pattern signal is continued; if the predetermined time has elapsed, the generation of the test pattern signal is discontinued and the drive condition is changed. In the electron beam tester 20, step S6 in Fig. 4B is omitted correspondingly.

Only when the condition signal Sdc which is received in the electron beam tester 20 upon each change of the drive condition in the above is a preset specified signal, the image data obtained at that time is displayed, and in other cases, the scanning of the IC by the electron beam EB is performed but the resulting image data need not be displayed. For instance, in the case where two different drive conditions are used and the images shown in Figs. 5C and 5D are alternately obtained, it is possible to display one of them by the condition signal Sdc and observe the potential distribution corresponding to the drive condition with sufficient time. Incidentally, when two drive conditions are used, the conditions signal Sdc needs only to be a signal which merely indicates that the drive condition has been switched to the other, but when three or more drive conditions are used, the condition signal Sdc needs to distinguish them from one another.

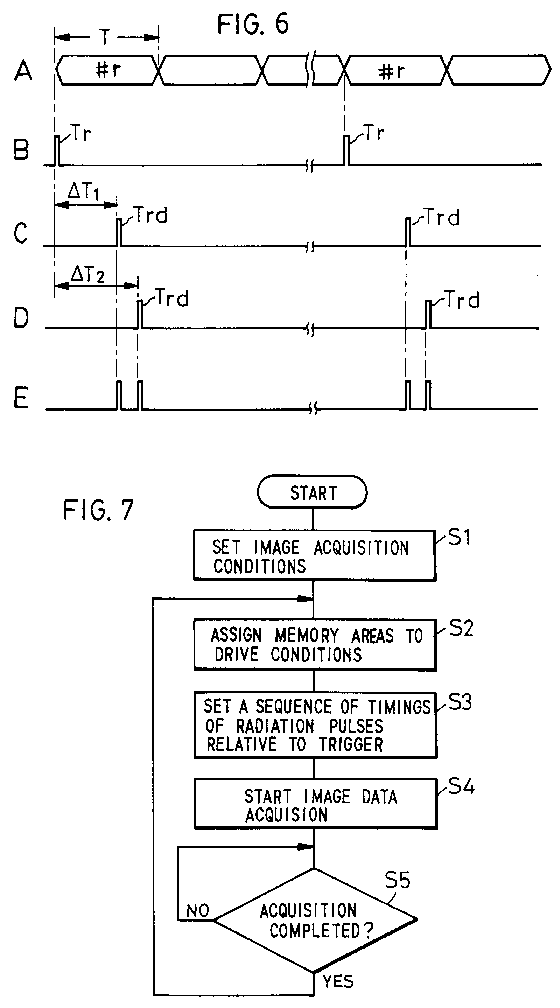

While the above embodiment has been described to obtain the secondary electron strobo image showing the operative state of the IC 15 at the point when the desired time $\Delta T$ has elapsed since the application of the desired test pattern to the IC 15, it is also possible to obtain images at different points in time after the reference timing by changing the delay time $\Delta T$ accordingly. In this instance, the drive condition is not switched to the other, but secondary electron strobo images in different operative states of the IC are obtained; consequently, the afore-mentioned results can be obtained. Hence, the condition signal generating part 12 in Fig. 2 can be left out. In such an instance, each time one-frame image data is acquired in the electron beam tester 20, the delay time $\Delta T$ for the trigger signal Tr and consequently the time of generation of the electron beam drive pulse Pe is changed. For example, as shown in Fig. 6-Row A, the test pattern signal #r is generated and the trigger signal Tr depicted in Fig. 6-Row B is generated correspondingly; in the acquisition of image data of a first frame, the electron beam drive pulse Pe is produced which is delayed by $\Delta T_1$ behind the trigger signal Tr as shown in Fig. 6-Row C. In the acquisition of image data of the nest frame, the electron beam drive pulse Pe is delayed by $\Delta T_2$ behind the trigger signal Tr as depicted in Fig. 6-Row D.

Alternatively, it is possible that the image data capturing operations based on the generation of the electron beam drive pulse Pe at such two different points in time are performed alternately for each pixel and that the image data thus acquired by each capturing operation is stored in a different area in the memory 17. The electron beam drive pulse Pe may be generated at more different points in time. The flow of operation by the electron beam tester 20 is such as shown in Fig. 7. That is, as referred to previously, the image capturing condition is set (step S1) as in step S1 shown in Fig. 4B. Then the area of the memory 17 in which to store the image data is set (step S2) and the irradiation pulse generating time for the trigger signal Tr is set (step S3). The irradiation pulse generating time is selected from among preset ones in a sequential order and the selected timing is set. To this end, the delay circuit 22 in Fig. 2 is formed as a variable delay circuit, which is adapted to permit the setting therein of the delay value $\Delta T$ from the control part 25. After the setting of the irradiation pulse generating time, the image capturing operation is started (step S4). Upon completion of the capturing of one-frame image data (step S5), the electron beam tester 20 returns to step S2, in which it changes the image data storage area, then changes the irradiation pulse generating time to a different one and captures image data again. Thereafter, the electron beam tester 20 repeats these operations.

In the case of changing the irradiation pulse generating time for the trigger signal Tr as described above, if the current operative state of the IC 15 is different from that prior to the change of the irradiation pulse generating time, the operative states of the IC 15 before and after the response to the test pattern applied thereto, for example, are detected and in this case, too, as described previously with reference to Figs. 5A and 5B, the images of conductor patterns having undergone potential variations appear clearly on the display, indicating the change in the IC operative state.

The embodiment of Fig. 2 may also employ a construction in which when the test pattern signal speed is relatively low (when a change in the delay time, $\Delta t = \Delta T_2 - \Delta T_1$, is longer than the time $\Delta t_s$ necessary for determining the position of deflection of the electron beam between pixels), the delay circuit 22 responds to the trigger signal Tr to generate the delayed pulses Trd at different points in time as shown in Fig. 6-Row E, the electron beam EB is applied to the IC 15 at the timing of each delayed pulse Trd and the resulting image data is stored in a different area of the memory 21. Fig. 6-Row E shows the case where the pulses Trd delayed by $\Delta T_1$ and $\Delta T_2$ behind the trigger signal Tr are generated and the electron beam drive pulse Pe is generated at the timing of each delayed pulse Trd. Upon each irradiation of the IC 15 with the electron beam EB in response to the electron beam drive pulse Pe, image data is captured; the pieces of image data thus captured are stored in different areas in the memory 17, and the image data captured on the basis of the pulse delayed by $\Delta T_1$ and the image data captured on the basis of the pulse delayed by $\Delta T_2$ are dis-

played on the display 24 alternately or in parallel, or the difference image obtained by the image processing part 24P is displayed. When the test cycle of the test pattern signal is fast and $\Delta t > \Delta t_s$, the Fig. 2 embodiment is operated as described previously in respect of Figs. 6-Rows B, C and D to test the IC in the same manner as described previously.

In the case of capturing image data at a plurality of different points in time with respect to the reference timing as described above, it is also possible to set a desired one of the different timings and display only the image data captured at the set timing. In any cases described above, when desired two of a plurality of pieces of strobo image data captured at different timings and the difference image data is obtained by the image processing part 24P, the display image can be made less affected by the charging of the IC protective coating. The delay time of the delay circuit 25 may preferably be set at will. It is also possible to freely set the timing for the generation of the trigger signal Tr by the test signal generator 12 for the generation of a desired test pattern, instead of setting the delay time.

As described above, according to this embodiment, since the drive condition or irradiation pulse generating timing is changed upon each capturing of a predetermined secondary electron strobo image, a change in the internal state of the IC by the change of the drive condition or irradiation pulse generating timing can surely be detected without being affected by the charging of the protective coating.

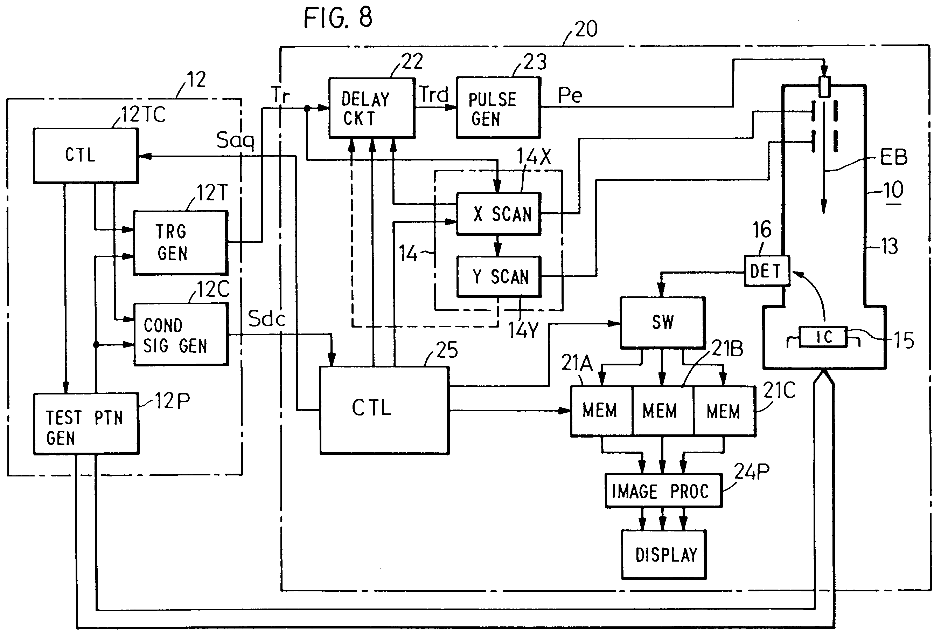

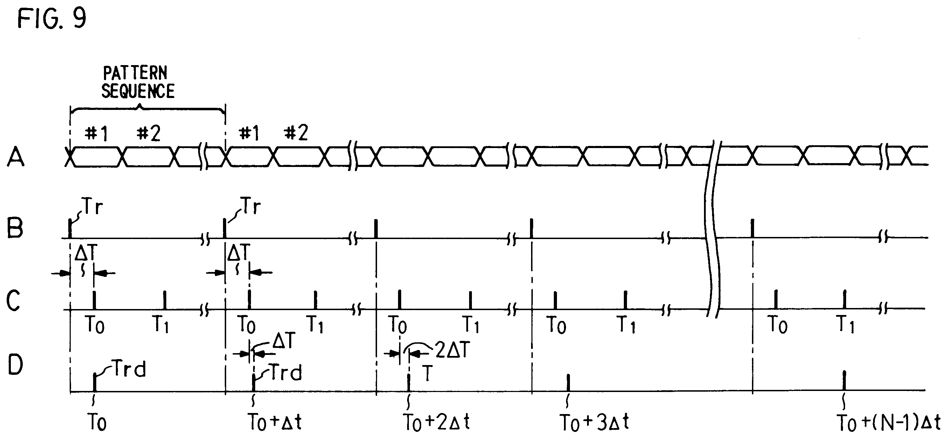

The above embodiments have each been described to capture the secondary electron emission strobo image at one or more timings on the basis of the trigger signal Tr for the selected test pattern, but it is also possible to employ a construction in which line image data of a different scanning line is captured at fixed time intervals after the generation of the trigger signal Tr for the selected test pattern and such line images are arranged in one display screen to display an image which shows temporal variations of the IC operative state (which image will hereinafter be referred to as an LSM image). An embodiment of this scheme will be described with reference to Figs. 8 and 9.

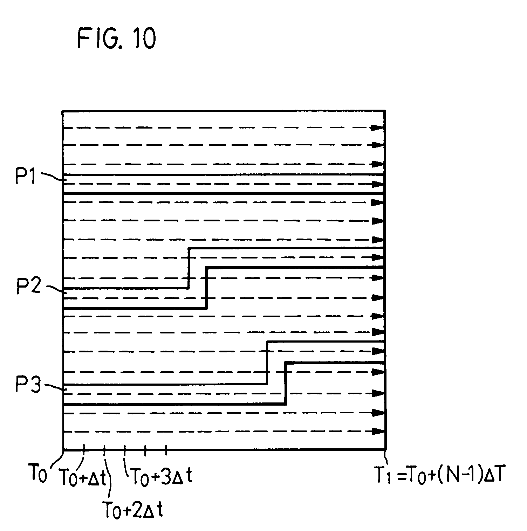

The embodiment of Fig. 8 is common to the Fig. 2 embodiment in basic construction but differs from the latter in that the scanning part 14 is adapted for scanning the IC 15 with the electron beam EB in synchronization with the trigger signal Tr. In this embodiment the captured pieces of image data are switched by a switch 17 so that they are stored alternately in memories 21A and 21B according to the different drive conditions used, but the pieces of image data may also be stored in different areas of one memory as in the case of the Fig. 2 embodiment. An electron beam tester is used as the charged particle beam tester 20 and the test signal generator 12 is connected to the tester 20. In the electron beam tester 20, the electron beam EB is generated pulse-wise in the vacuum chamber 13 and is applied to the IC 15 placed in the chamber 13. Secondary electrons emitted by the irradiation with the electron beam EB are detected by the secondary electron detector 16 and the detected output is stored as image data in either one of the image memories 21A and 21B. Fig. 10 shows scanning lines (indicated by the broken-line arrows) of the electron beam over a desired surface area of the IC 15 where the conductors P1, P2 and P3 are included and delay times for the trigger signal Tr which designate the image data capturing timing (i.e. the timing for the irradiation with the electron beam pulse) for each point corresponding to each pixel in the horizontal-axis direction.

A sequence of test patterns from the test pattern generating part 12P in the test signal generator 12 and the power supply voltage are provided as a drive signal to the IC 15 to drive it. In synchronization with the generation of a desired one of the test patterns the trigger signal generating part 12T generates the trigger signal Tr, which is applied to the delay circuit 22 in the electron beam tester 20. When the drive conditions for the IC 15, such as the sequence of test patterns, the pattern sequence, the phase of the pattern to be applied, the test cycle period and the operating power supply voltage, are changed, the condition signal Sdc indicating the change is provided from the condition signal generating part 12C to the control part 25 of the electron beam tester 20. Though not shown, various test conditions of the electron beam tester 20 can be set in the control part 25, which controls respective parts in accordance with the set test conditions. An X scanning part 14X and a Y scanning part 14Y are also controlled by the control part 25 to control the deflection of the electron beam EB for horizontal and vertical scanning of the set surface area of the IC 15.

For instance, a sequence of test patterns #1 through #K shown in Fig. 9-Row A are repeatedly generated, and as shown in Fig. 9-Row B, the trigger signal Tr is generated at the point of start of a desired one of the test patterns, the test pattern #1 in the example. In the control part 25 there are preset the period for capturing image data from the timing point $T_0$ to $T_1$ as shown in Fig. 9-Row C. When the number of pieces of data to be captured for each horizontal scanning line is preset to N, the unit time $\Delta t = (T_1 - T_0)/(N - 1)$, is provided and the delay time of the delay circuit 22 is initially set to $t_1$

$= T_0$. The first trigger signal Tr is delayed by $t_1 = T_0$ in the delay circuit 22 and is input into the pulse generator 23, and in response to the pulse Pe from the pulse generator 23, the pulse of the electron beam EB is emitted to the IC 15 and secondary electrons therefrom are detected. In this way, upon each generation of the trigger signal Tr, the delay time relative to $t_1 = T_0$ is incremented by $\Delta t$ as shown in Fig. 9-Row D, and in response to the pulse Prd delayed correspondingly, the electron beam drive pulse Pe is produced; thus, image data of one pixel is written into the memory 21A or 21B. Upon each writing of the image data of one pixel, the electron beam EB is shifted by one-pixel distance in the horizontal direction. That is, each time the electron beam EB is shifted by one-pixel distance in the horizontal direction under the control of the X scanning pat 14X, the delay time set in the delay circuit 22 is incremented by $\Delta t$.

In the manner described above, the pieces of image data at the timing points $T_0$ to $T_1$ are captured by one horizontal scanning and image data for each horizontal scanning is similarly loaded into the memory 21A, for example; upon completion of the loading of one-frame image data, the acquisition completion signal Saq is sent to the test signal generator 12. When having received the acquisition completion signal Saq, the test signal generator 12 changes the drive conditions, for example, changes the power supply voltage from 5 volts for the normal operation of the IC 15 to 4 volts for an abnormal operation of the IC 15, and then test signal generator 12 generates the condition signal Sdc. Again, the sequence of test pattern signals and the trigger signal Tr are generated, and as described previously with respect to Fig. 2, upon each generation of the trigger signal Tr, the electron beam tester 20 emits an electron beam pulse correspondingly shifted in timing and captures image data into the memory 21B.

This is followed by repeating the same operations of generating the acquisition completion signal Saq upon each loading of one-frame image data into the memory, changing the drive conditions from the one to the other upon each reception of the acquisition completion signal Saq and generating the condition signal Sdc, the test pattern signal and the trigger signal Tr accordingly. Furthermore, upon each reception of the condition signal Sdc, the loading of the image data is switched by the switch 17 between the image memories 21A and 21B.

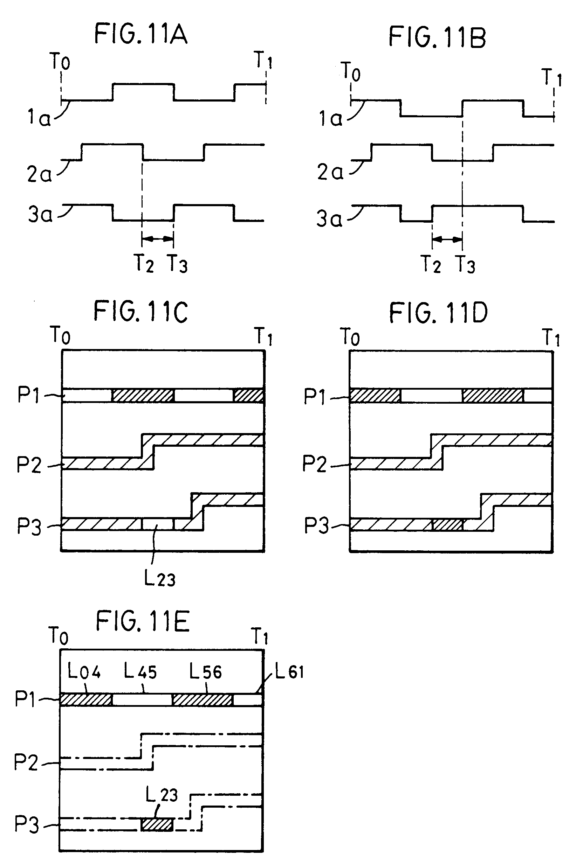

Now, let it be assumed that when the operating power supply voltage for the IC 15 is 5 volts, potential variations of three conductors (indicated by the corresponding conductor pattern images P1, P2 and P3 since they are not shown) on the IC 15 in the time interval from the timing $T_0$ to $T_1$ are

such as indicated by the waveforms 1a, 2a and 3a in Fig. 11A and that the IC 15 is in normal operation. On the other hand, suppose that when the power supply voltage is changed to 4 volts, the potential variations on the three conductors P1, P2 and P3 in the time interval between the timing $T_0$ and $T_1$ are such as indicated by the waveforms 1a, 2a and 3a in Fig. 11B. That is, the conductor P1 has the polarity of its potential pattern reversed; the conductor P2 keeps the same potential pattern; and the conductor P3 has the polarity of its potential pattern reversed only in the interval between the timing $T_2$ and $T_3$.

In the case of repeatedly capturing the image data under an alternate one of the above-mentioned drive conditions in such a state and display each image data on the display part 24, the image captured under the normal state of the IC in Fig. 11A is such as shown in Fig. 11C; Fig. 11B shows the image in the immediately previous state. That is, the conductor pattern image P1 is displayed white at the low level of the waveform 1a and black at the high level thereof. The conductor pattern image P2 is displayed gray, irrespective of whether the waveform 2a is high- or low-level. The reason for this is that since the voltage pattern 2a (Fig. 11B) of the conductor P2 remains identical with the voltage pattern 2a shown in Fig. 11A even after the power supply voltage has been changed to 4 volts, the conductor P2 undergoes no potential variations under two drive conditions for place and time in the time interval between the timing $T_0$ and $T_1$ irrespective of the change in the drive condition, allowing the protective insulating layer on the conductor P2 to be charged. This is the same phenomenon as that pointed out previously in connection with the prior art. The conductor pattern image P3 becomes white at the low level in the period $L_{23}$ corresponding to the time interval between the timing $T_2$ and $T_3$ but the other remaining part is displayed gray since it does not undergo any potential variation by the change of the drive conditions for place and time.

On the other hand, the image captured under the abnormal condition of the IC 15 in Fig. 11B (the immediately previous state being shown in Fig. 3A) becomes such as shown in Fig. 11D. That is, the conductor pattern image P1 is displayed black at the high level of the waveform 1a and white at the low level thereof; the conductor pattern image P2 is displayed gray since the conductor does not undergo any potential variations as in the case of Fig. 11C; and the conductor pattern image P3 is displayed black at the part $L_{23}$ corresponding to the high level of the waveform 3a in the period from $T_2$ to $T_3$ during which the conductor potential varied by the switching of the operation and the other remaining part is displayed gray.

As is evident from Figs. 11C and 11D, when the IC operative state is changed, that is, when the power supply voltage is decreased to 4 volts in this example, the conductor pattern image P1 is displayed as exactly the reverse of that during the normal operation, from which it is understood that the operative state of the IC 15 has turned abnormal and that the IC operation differs from the normal operation in terms of location and time. It is seen from Figs. 11C and 11D, however, that the conductor P2 remains normal and that the conductor P3 has become abnormal from the high to low level in the portion $L_{23}$ thereon only in the period from the timing $T_2$ to $T_3$.

Furthermore, the image data shown in Fig. 11C is subtracted by the image processing part 24P from the image data in Fig. 11D; Fig. 11E shows the display image of the resulting difference image data. In the conductor pattern image P1, parts $L_{04}$ and $L_{56}$ where the low level during the normal operation has changed to the high level are displayed black and parts $L_{45}$ and $L_{51}$ where the high level during the normal operation has changed to the low level are displayed white. The conductor pattern image P2, which remains unchanged irrespective of the change in the drive condition, does not even appear on the display screen. In the conductor pattern image P3, only the part $L_{23}$ which has changed from the low to the high level is displayed black but the other remaining parts do not appear on the display screen. In the display of Fig. 11E, only the abnormal portions appear more clearly than in the displays of Figs. 11C and 11D. The displays of Figs. 11C and 11D are inferior to that of Fig. 11E in terms of clarity but allow ease in recognizing the physical and temporal positions of a faulty component, since every conductor pattern image appears in the displays.

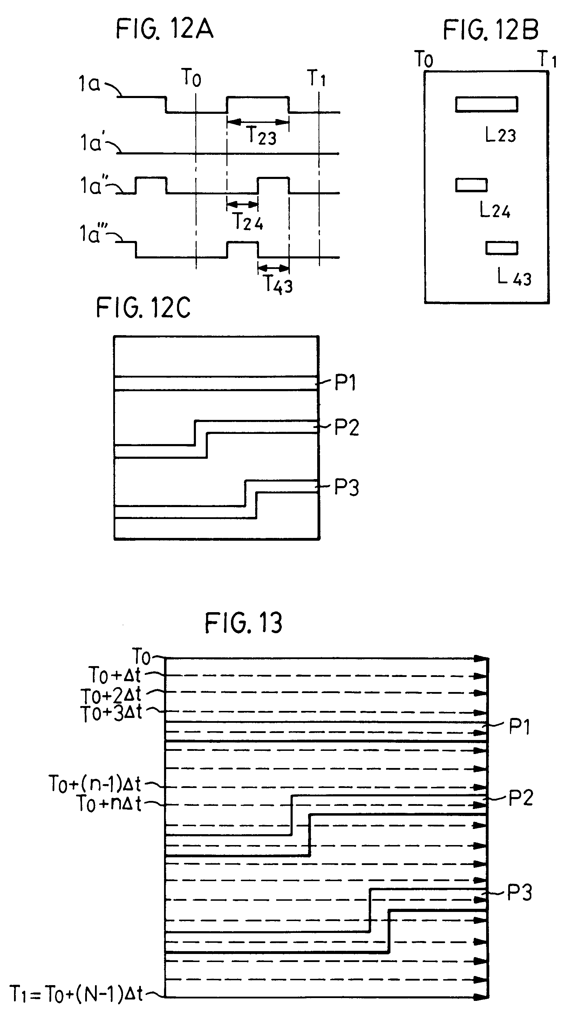

In the case where the potential of the conductor P1, such as indicated by the waveform 1a in Fig. 12A when the power supply voltage is 5 volts, remains low-level as indicated by the waveform 1a' in Fig. 12A when the power supply voltage is decreased to 4 volts, the difference image such as described above in respect of Fig. 11E is displayed white in a portion $L_{23}$ where the potential has changed from the high to the low level, as indicated by an image $L_{23}$ in Fig. 12B. In the case where the first half $T_{24}$ of the high-level portion in the waveform 1a becomes low-level owing to the decrease in the power supply voltage as indicated by the waveform 1a'', only the portion $T_{24}$ of the difference image appears as a white image $L_{24}$ as shown in Fig. 12B. When the latter half $T_{43}$ of the high-level portion in the curve 1a becomes low-level as indicated by the waveform 1a''', only the portion $T_{43}$ of the difference image appears as a white image $L_{43}$ as shown in Fig. 12B. Thus, according to the present invention, temporal changes of the conductor potentials can also be known.

It is also possible to clearly display the part to be noted and facilitate the reading of its location on the IC 15. To implement this, the strobo image, for example, is obtained by detecting secondary electrons which are emitted from the IC 15 by irradiating its surface with the scanning electron beam EB while holding the IC 15 inoperative, or by repeatedly irradiating the surface of the IC 15 with the electron beam EB while holding the IC 15 in a certain operative state though applying thereto a test pattern, and the static configuration data (the image data) of the IC surface is acquired from the strobo image; that is, for the IC portion corresponding to the display shown in Fig. 11C, for example, provision is made for displaying the three conductor pattern images P1, P2 and P3 by their boundary lines only as shown in Fig. 12C. The thus obtained static configuration data is stored in a memory 21C, and this data and the difference image data (corresponding to Fig. 11E) are displayed while being overlapped with each other.

In the above, the delay of the electron beam irradiation timing is incremented by $\Delta t$ upon each horizontal shifting of the electron beam, that is, the image data is acquired in such a manner that the horizontal direction on the display screen becomes the time axis; but the image data may also be captured so that the vertical direction on the display screen becomes the time axis. In this instance, as shown in Fig. 13, the electron beam irradiation timing for the trigger signal Tr is set to a fixed value $T_0 + (n-1)\Delta t$ on the same horizontal scanning line, and on the next horizontal scanning line, the electron beam irradiation timing is delayed by $\Delta t$ behind the trigger signal Tr to perform the electron beam irradiation at the timing $T_0 + n\Delta t$. In order that every horizontal scanning line may start at the same vertical line, the timing for starting the horizontal scanning needs to be advanced by $\Delta t$ upon each capture of the image data of one scanning line.

In the case of incrementing the delay of the electron beam irradiation timing by $\Delta t$ in one horizontal scanning, the vertical scanning may be done randomly; that is, the numbers of horizontal scanning lines are arranged randomly and the horizontal line numbers are selected one by one upon each horizontal scanning. Furthermore, in the case where the image data is captured so that the time axis becomes vertical as referred to previously, it is possible to arrange pixel position numbers on each horizontal scanning line randomly and apply the electron beam to the pixel positions selected in order of arrangement. Such random horizontal or vertical scanning eliminates the possibility of adjacent points on IC surface being continuously irradiated with the electron beam--this lessens the influence of the charge of the protective insulating coating. This scheme is particularly effective in increasing positional resolution.

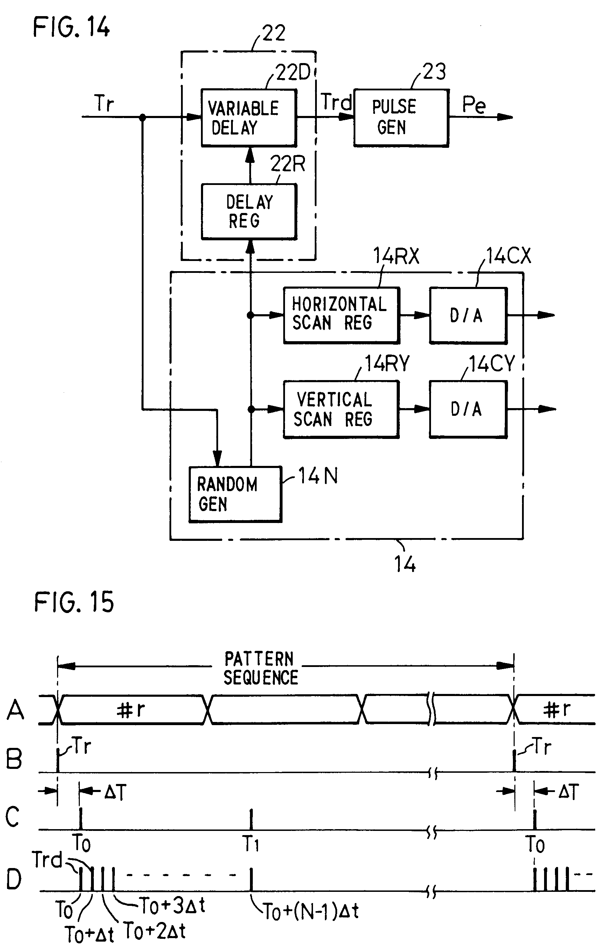

Similarly, both horizontal and vertical scanning can also be performed randomly. In this instance, for example, as shown in Fig. 14, horizontal position data for deflecting the electron beam to each point on the horizontal scanning line is stored in a horizontal deflection register 14RX, vertical position data for deflecting the electron beam to each point on the vertical scanning line is stored in a vertical deflection register 14RY, and data which indicates the electron beam irradiation timing (i.e. the delay for the trigger signal Tr) for each pixel point on one horizontal scanning line is stored in a delay register 22R. A number indicating the position of each point over the entire scanning area is generated by a random generator 14N. The low-order bit of the number is used as a readout address to read out the horizontal deflection register 14RX and the delay register 22R, and the high-order bit of the number is used as an address to read out the vertical deflection register 14RY. The data thus read out from the horizontal deflection register 14RX is converted by a D/A converter 14CX to an analog signal, which is applied to a horizontal deflector. The data read out from the vertical deflection register 14RY is converted by a D/A converter to an analog signal, which is applied to a vertical deflector. The data read out from the delay register 22R is set in a variable delay circuit 22D which delays the trigger signal Tr, and the output from the variable delay circuit 22D is provided to the pulse generator 23.

In the image data capturing operation of Fig. 9 described as an example of the operation of the Fig. 8 embodiment, the phase lag (i.e. the delay time) is incremented by $\Delta t$ for each trigger signal Tr which is generated upon each repetition of the sequence of test patterns, but when the phase shift amount $\Delta t$ is larger than the time $\Delta t_s$ necessary for determining the position of deflection of the electron beam between pixels, it is also possible to employ a construction in which N pulses Trd (corresponding to one scanning line) delayed by $\Delta t$ one after another from the timing point $T_0$ to $T_1$ are generated upon each generation of the trigger signal Tr as shown in Fig. 15, for example, and the secondary electron emission image data of one scanning line is captured. That is, when the trigger signal Tr shown in Fig. 15-Row B is generated in synchronization with the pattern #r upon each repetition of the sequence of test patterns shown in Fig. 13-Row A, the N pulses Trd delayed by $\Delta t$ in a sequential order are provided from the delay circuit 22 one after another as shown in Fig. 15-Row D in the period from the timing $T_0$ to $T_1$ (Fig. 15-Row

C) corresponding to the period of a desired scanning line set by the control part 25.

Such a delay circuit can be formed, for example, by a variable delay unit which delays the trigger signal Tr by $\Delta T$ and at least N-1 cascade-connected delay elements which are supplied with the delayed output from the variable delay unit and each of which has the delay time $\Delta t$. The $\Delta T$-delayed output from the variable delay unit and the outputs from the N-1 delay elements are outputted as one pulse train by a wired OR, for example, and they are provided to the pulse generator 23. The pulse generator 23 responds to these N delayed pulses Trd to generate the electron beam drive pulses Pe in a sequential order. As a result, image data of one scanning line is obtained upon each repetition of the sequence of test patterns, and by repeating the cyclic generation of the test patterns by a required number of scanning lines, the LSM image data of one frame can be obtained.

While in the above the image data capturing operations under two drive conditions are performed alternately with each other, it is possible to accumulate and average the image data under the same drive condition so as to increase the SN ratio. In the case of automatically changing the drive condition at the test signal generator 12 side taking into account the maximum amount of time necessary for capturing one-frame image data, the acquisition completion signal need not be generated at the electron beam tester 20 side. In the above, the drive condition is changed upon each capture of one-frame data, but the drive condition may be changed upon each capturing of image data of a predetermined area of one frame such as one half frame.

As described above, according to this embodiment, since the drive conditions such as the power supply voltage and the test pattern clock frequency are alternately switched upon each capturing the LSM image data of a predetermined area of one frame, the image of the noted place on the IC surface can clearly be displayed without being affected by the insulating protective coating.

It will be apparent that many modifications and variations may be effected without departing from the scope of the novel concepts of the present invention.

## Claims

1. A semiconductor IC potential distribution image capturing apparatus which applies a drive signal containing repetition of a sequence of test patterns to a semiconductor integrated circuit placed in a charged particle beam irradiation device, irradiates said semiconductor integrated circuit with a charged particle beam in a pulse-wise manner while scanning said integrated circuit over a predetermined surface area, detects the amount of secondary electron emission from every irradiated point and obtains a potential distribution image of said semiconductor integrated circuit, said apparatus comprising:

   pulse generating means for generating a charged particle beam pulse at desired timing on the basis of a trigger signal supplied thereto in synchronization with the generation of a desired test pattern in each repetition of said sequence of said test patterns;

   scanning means for scanning a desired area of said semiconductor integrated circuit with said charged particle beam pulse;

   image data capturing means which detects the amounts of secondary electron emission from respective points on said semiconductor integrated circuit irradiated with said charged particle beam pulse, for capturing image data corresponding to each pixel;

   means for causing said image data capturing means to capture said image data of a predetermined frame upon each application of an updated drive condition signal which designates one of a plurality of predetermined drive conditions for said semiconductor integrated circuit;

   storage means for storing said image data in association with each of said drive conditions; and

   display means whereby said image data read out from said storage means is displayed as an image.

2. A semiconductor IC potential distribution image capturing apparatus which applies a drive signal containing repetition of a sequence of test patterns to a semiconductor integrated circuit placed in a charged particle beam irradiation device, irradiates said semiconductor integrated circuit with a charged particle beam in a pulse-wise manner while scanning said integrated circuit over a predetermined surface area, detects the amount of secondary electron emission from every irradiated point and obtains a potential distribution image of said semiconductor integrated circuit, said apparatus comprising:

   pulse generating means for generating a charged particle beam pulse at desired timing on the basis of a trigger signal supplied thereto in synchronization with the generation of a desired test pattern in each repetition of said sequence of test patterns;

   scanning means for scanning a desired area of said semiconductor integrated circuit with said charged particle beam pulse;

image data capturing means which detects the amounts of secondary electron emission from respective points on said semiconductor integrated circuit irradiated with said charged particle beam pulse, for capturing image data corresponding to each pixel;

means for changing said timing for the generation of said charged particle beam pulse with respect to said trigger signal upon each capturing of said image data for one frame;

storage means for storing said image data in association with said timing; and

display means whereby said image data read out from said storage means is displayed as an image.

3. A semiconductor IC potential distribution image capturing apparatus which applies a drive signal containing repetition of a sequence of test patterns to a semiconductor integrated circuit placed in a charged particle beam irradiation device, irradiates said semiconductor integrated circuit with a charged particle beam in a pulse-wise manner while scanning said integrated circuit over a predetermined surface area, detects the amount of secondary electron emission from every irradiated point and obtains a potential distribution image of said semiconductor integrated circuit, said apparatus comprising:

pulse generating means for generating said charged particle beam pulse at a plurality of sequentially shifted timing points on the basis of a trigger signal supplied thereto in synchronization with the generation of a desired test pattern in each repetition of said sequence of test patterns;

scanning means for scanning a desired area of said semiconductor integrated circuit with said charged particle beam pulse;

image data capturing means which detects the amounts of secondary electron emission from respective points on said semiconductor integrated circuit irradiated with said charged particle beam pulse, for capturing image data corresponding to each pixel;

storage means for storing said image data in association with each of said timing points; and

display means whereby said image data read out from said storage means is displayed as an image.

4. The apparatus of claim 1, further comprising: drive signal generating means for generating said drive signal containing said sequence of test patterns; trigger signal generating means for generating said trigger signal in synchronization with the generation of said desired test pattern in each repetition of said sequence of test patterns; and condition signal generating means for generating said condition signal which designates the drive condition for said semiconductor integrated circuit.

5. The apparatus of claim 2 or 3, further comprising: drive signal generating means for generating said drive signal containing said sequence of test patterns; and trigger signal generating means for generating said trigger signal in synchronization with the generation of said desired test pattern in each repetition of said sequence of test patterns.

6. The apparatus of any one of claim 1, 2 or 3, further comprising variable delay means for delaying said trigger signal by a desired time interval to change the timing for the generation of said charged particle beam pulse.

7. The apparatus of any one of claim 1, 2 or 3, further comprising image processing means which obtains the difference between pieces of image data captured corresponding to a plurality of frame and causes said display means to display image data of said difference.

8. The apparatus of claim 1 or 4, further comprising means whereby a check is made to determine if said condition signal indicates a preset specific IC drive condition and, only when said specific IC drive condition is detected, captured image data corresponding to said specific IC drive condition is displayed on said display means.

9. The apparatus of claim 4, wherein said drive signal generating means includes means for changing said IC drive condition at predetermined time intervals.

10. The apparatus of claim 4, further comprising acquisition signal generating means for generating an acquisition signal upon each completion of capturing image data of one frame.

11. The apparatus of claim 10, wherein said drive signal generating means includes means which changes said drive condition upon receiving said acquisition signal.

12. The apparatus of claim 2 or 3, further comprising means whereby only a selected frame in said captured image data of a plurality of frames is displayed on said display means.

13. A semiconductor IC potential distribution image capturing apparatus which applies a drive signal containing repetition of a sequence of test patterns to a semiconductor integrated circuit placed in a charged particle beam irradiation device, irradiates said semiconductor integrated circuit with a charged particle beam in a pulse-wise manner while scanning said integrated circuit over a predetermined surface area, detects the amount of secondary electron emission from every irradiated point and obtains a potential distribution image of said semiconductor integrated circuit, said apparatus comprising:

delay means whereby a trigger signal applied thereto in synchronization with the generation of a desired test pattern in said sequence of test patterns is delayed by a time interval corresponding to the position of horizontal or vertical scanning of said semiconductor integrated circuit with said charged particle beam and a delay pulse is generated, said charged particle beam irradiation device responding to said delay pulse to generate a charged particle beam pulse;

scanning means for scanning a desired area of said semiconductor integrated circuit with said charged particle beam pulse;

image data capturing means which detects the amounts of secondary electron emission from respective points on said semiconductor integrated circuit irradiated with said charged particle beam pulse, for capturing image data corresponding to each pixel;

means for causing said image data capturing means to capture said image data of a predetermined frame upon each changing of a condition signal which designates one of a plurality of predetermined drive conditions for said semiconductor integrated circuit;

storage means for storing said image data in association with said IC drive condition; and

display means whereby said image data read out from said storage means is displayed as an image.

14. The apparatus of claim 13, further comprising: drive signal generating means for generating said drive signal containing repetition of said sequence of test patterns; trigger signal generating means for generating said trigger signal in synchronization with the generation of a desired test pattern in each repetition of said sequence of test patterns; and condition signal generating means for generating said condition signal which designates the drive condition for said semiconductor integrated circuit.

15. The apparatus of claim 13 or 14, further comprising image processing means for providing, as difference image data, the difference between pieces of image data stored in said storage means in association with said IC drive conditions.

16. The apparatus of claim 15, further comprising means for storing pattern configuration information of said semiconductor integrated circuit, and wherein said display means provides overlapping displays of said pattern configuration information and said difference image data.

17. The apparatus of claim 13 or 14, wherein said delay means is means which performs said delay by incrementing a preset delay time by a predetermined value upon each unit shift of said horizontal or vertical scanning.

18. The apparatus of claim 17, wherein said scanning means generates at least one of horizontal lines and vertical scanning lines in random order.

19. The apparatus of claim 13 or 14, wherein said scanning means includes means for randomly scanning said semiconductor integrated circuit and said delay means is means which reads out prestored delay data in accordance with the horizontal or vertical position of said random scanning and sets said delay data in said delay means for delaying said trigger signal.

20. A semiconductor IC potential distribution image capturing method which generates a drive signal containing repetition of a sequence of test patterns by test signal generating means, applies said drive signal to a semiconductor integrated circuit placed in a charged particle beam irradiation device to drive it, irradiates said semiconductor integrated circuit with a charged particle beam, measures the secondary electron emission therefrom and obtains its potential distribution image, said method comprising the steps of:

(a) generating, by said test signal generating means, a condition signal which indicates one of a plurality of predetermined IC drive conditions;

(b) applying said drive signal from said test signal generating means to said semiconductor integrated circuit to drive it under the drive condition designated by said condition signal;

(c) generating a delayed pulse delayed for a desired time behind the point of generation of a desired test pattern in each repetition of said sequence of test patterns;

(d) generating a charged particle beam pulse by said charged particle beam irradiation device in response to said delayed pulse;

(e) irradiating said semiconductor integrated circuit with said charged particle beam pulse while scanning it over a desired area and detecting the amounts of secondary electron emission from irradiated points on said semiconductor integrated circuit to obtain image data corresponding to each pixel;

(f) loading said image data into memory means in association with said drive condition;

(g) repeating said steps (c), (d), (e) and (f);

(h) upon completion of capturing said image data of one frame, changing said drive condition and performing said steps (a) through (g); and

(i) processing and displaying image data stored in said memory means in association with said drive conditions, respectively.

21. The method of claim 20, wherein said step (h) includes a step wherein an acquisition completion signal is generated upon completion of capturing said image data and said test signal generating means responds to said acquisition completion signal to change said drive condition.

22. The method of claim 20, wherein said plurality of IC drive conditions are a condition for normal operation of said semiconductor integrated circuit and a condition for abnormal operation of said semiconductor integrated circuit.

23. A semiconductor IC potential distribution image capturing method which generates a drive signal containing repetition of a sequence of test patterns by test signal generating means, applies said drive signal to a semiconductor integrated circuit placed in a charged particle beam irradiation device to drive it, irradiates said semiconductor integrated circuit with a charged particle beam, measures the secondary electron emission therefrom and obtains its potential distribution image, said method comprising the steps of:

(a) applying said drive signal from said test signal generating means to said semiconductor integrated circuit to drive it;

(b) generating a delayed pulse delayed for a predetermined period of time behind the point of generation of a desired test pattern in each repetition of said sequence of test patterns;

(c) generating a charged particle beam pulse by said charged particle beam irradiation device in response to said delayed pulse;

(d) irradiating said semiconductor integrated circuit with said charged particle beam pulse while scanning it over a desired area and detecting the amounts of secondary electron emission from irradiated points on said semiconductor integrated circuit to obtain image data corresponding to each pixel;

(e) loading said image data into memory means in association with said predetermined time;

(f) repeating said steps (b), (c), (d) and (e);

(g) upon completion of capturing said image data of one frame, changing said predetermined time and performing said steps (a) through (f); and

(h) processing and displaying said image data stored in said memory means in association with said plurality of predetermined periods of time, respectively.

24. The method of claim 23, wherein said plurality of predetermined periods of time are two predetermined periods of time, and which further comprises a step of capturing said image data of one frame a plurality of times for alternate one of said two predetermined periods of time and accumulating said image data for each of said two predetermined periods of time to obtain averaged image data for said each predetermined period of time.

25. The method of claim 24, further comprising a step of obtaining image data of the difference between said pieces of averaged image data for said two predetermined periods of time and displaying said difference image data as an image.

26. A semiconductor IC potential distribution image capturing method which generates a drive signal containing repetition of a sequence of test patterns by test signal generating means, applies said drive signal to a semiconductor integrated circuit placed in a charged particle beam irradiation device to drive it, irradiates said semiconductor integrated circuit with a charged particle beam, measures the secondary electron emission therefrom and obtains its potential distribution image, said method comprising the steps of:

(a) applying said drive signal from said test signal generating means to said semiconductor integrated circuit to drive it;

(b) generating a plurality of delayed pulses respectively delayed for a plurality of different periods of time behind the point of generation of a desired test pattern in each repetition of said sequence of test patterns;

(c) generating a charged particle beam pulse by said charged particle beam irradiation device a plurality of times in response to said plurality of delayed pulses, respectively;

(d) irradiating said semiconductor integrated circuit with said charged particle beam pulse said plurality of times at the same point while scanning it over a desired area and detecting the amounts of secondary electron emission from said irradiated points to obtain a plurality of pieces of image data of the same pixel corresponding to said plurality of delay times;

(e) loading said plurality of pieces of image data into memory means in association with said plurality of delay times;

(f) repeating said steps (b), (c), (d) and (e); and

(g) upon completion of capturing said image data of one frame for each of said plurality of delay times in said step (f), processing and displaying said image data stored in said memory means in association with said plurality of delay times.

27. The method of claim 26, wherein said plurality of delay times are two delay times, and which further comprises a step of capturing said image data of one frame a plurality of times for alternate one of said two delay times and accumulating said image data for each of said two delay times to obtain averaged image data for said each delay time.

28. The method of claim 27, further comprising a step of obtaining image data of the difference between said pieces of averaged image data for said two delay times and displaying said difference image data as an image.

29. A semiconductor IC potential distribution image capturing method which generates a drive signal containing repetition of a sequence of test patterns by test signal generating means, applies said drive signal to a semiconductor integrated circuit placed in a charged particle beam irradiation device to drive it, irradiates said semiconductor integrated circuit with a charged particle beam, measures the secondary electron emission therefrom and obtains its potential distribution image, said method comprising the steps of:

(a) generating, by said test signal generating means, a condition signal which indicates one of a plurality of predetermined drive conditions;

(b) applying said drive signal from said test signal generating means to said semiconductor integrated circuit to drive it under the drive condition designated by said condition signal;

(c) generating a trigger signal in synchronization with the point of generation of a desired test pattern in each repetition of said sequence of test patterns;

(d) generating a delayed pulse by delaying said trigger signal by a time interval corresponding to one scanning point on one of horizontal and vertical scanning lines by said charged particle beam in a predetermined area of said semiconductor integrated circuit;

(e) generating a charged particle beam pulse by said charged particle beam irradiation device in response to said delayed pulse;

(f) irradiating said semiconductor integrated circuit with said charged particle beam pulse at said one scanning point in said predetermined area and detecting the amount of secondary electron emission from said irradiated point to obtain image data corresponding to a pixel;

(g) loading said image data into memory means in association with said drive condition;

(h) repeating said steps (c), (d), (e), (f) and (g);

(i) upon completion of capturing said image data of one frame in said step (h), changing said drive condition and performing said steps (a) through (h); and

(j) processing and displaying said image data loaded in said memory means in association with said drive conditions.

30. A semiconductor IC potential distribution image capturing method which generates a drive signal containing repetition of a sequence of test patterns by test signal generating means, applies said drive signal to a semiconductor integrated circuit placed in a charged particle beam irradiation device to drive it, irradiates said semiconductor integrated circuit with a charged particle beam, measures the secondary electron emission therefrom and obtains its potential distribution image, said method comprising the steps of:

(a) generating, by said test signal generating means, a condition signal which indicates one of a plurality of predetermined IC drive conditions;

(b) applying said drive signal from said test signal generating means to said semiconductor integrated circuit to drive it under the drive condition designated by said condition signal;

(c) generating a trigger signal by said test signal generating means in synchronization with the point of generation of a desired test pattern in each repetition of said sequence of test patterns;

(d) delaying said trigger pulse by time intervals corresponding to respective scanning points on one of horizontal and vertical scanning lines by said charged particle beam in a predetermined area of said semiconductor integrated circuit to thereby sequentially generate delayed pulses respectively corresponding to said scanning points;

(e) generating charged particle beam pulses respectively corresponding to said scanning points on said one scanning line by said charged particle beam irradiation device in response to said delayed pulses;

(f) irradiating said semiconductor integrated circuit with said charged particle beam pulses at said scanning points respectively corresponding thereto in said predetermined area and detecting the amounts of secondary electron emission from said irradiated points in a sequential order to obtain image data corresponding to one scanning line;

(g) loading said image data into memory means in association with said drive condition;

(h) repeating said steps (c), (d), (e), (f) and (g);

(i) upon completion of capturing said image data of one frame in said step (h), changing said drive condition and performing said steps (a) through (h); and

(j) processing and displaying said image data stored in said memory means in associated with said drive conditions.

31. The method of claim 20, 29, or 30, wherein said plurality of drive conditions are two drive conditions, and which further comprises a step of capturing said image data of one frame a plurality of times for alternate one of said two drive conditions and accumulating said image data for each of said two drive conditions to obtain averaged image data for each drive condition.

32. The method of claim 31, further comprising a step of obtaining image data of the difference between said pieces of averaged image data for said two drive conditions and displaying said deference image data as an image.

PRIOR ART

FIG.1A

P1
P2
P3
P4

FIG.1B

P1
P2
P3
P4

FIG.1C

P1
P2
P3
P4

# FIG. 2

EP 0 652 444 A1

FIG. 3

A SEQUENCE OF PATTERNS

# FIG. 4A

```
        START
          │
          ▼
┌──────────────────┐  S1
│   SET DRIVE      │
│   CONDITIONS     │
└──────────────────┘
          │
          ▼
┌──────────────────┐  S2
│   GENERATE       │
│   CONDITION SIG  │
└──────────────────┘
          │
          ▼
┌──────────────────┐  S3
│   GENERATE       │
│   TEST PATTERNS  │
└──────────────────┘
          │
          ▼
┌──────────────────┐  S4
│   GENERATE       │
│   TRIGGER SIG    │
└──────────────────┘
          │
          ▼
        ╱────────╲  S5
   NO  ╱ ACQUISITION╲
 ◄────╱  COMPLETION  ╲
      ╲    SIG ?    ╱
       ╲──────────╱
          │ YES
          ▼
┌──────────────────┐  S6
│   HALT SIGNAL    │
│   GENERATION     │
└──────────────────┘
          │
          ▼
┌──────────────────┐  S7
│   ALTER DRIVE    │
│   CONDITIONS     │
└──────────────────┘
```

# FIG. 4B

```
        START
          │
          ▼
┌──────────────────┐  S1
│ SET IMAGE        │
│ ACQUISITION      │
│ CONDITIONS       │
└──────────────────┘
          │
          ▼
        ╱────────╲  S2
   NO  ╱ CONDITION ╲
 ◄────╱  SIGNAL ?   ╲
      ╲            ╱
       ╲──────────╱
          │ YES
          ▼
┌──────────────────┐  S3
│ ASSIGN MEMORY    │
│ AREAS TO DRIVE   │
│ CONDITIONS       │
└──────────────────┘
          │
          ▼
┌──────────────────┐  S4
│ START IMAGE DATA │
│ ACQUISITION      │
└──────────────────┘
          │
          ▼
        ╱────────╲  S5
   NO  ╱ ACQUISITION╲
 ◄────╱  COMPLETED?  ╲
      ╲            ╱
       ╲──────────╱
          │ YES
          ▼
┌──────────────────┐  S6
│ GENERATE ACQ     │
│ COMP SIG         │
└──────────────────┘
          │
          ▼
        END
```

21

FIG. 5A

P1 —— H
P2 —— H
P3 —— L
P4 —— L

FIG. 5B

P1 —— H
P2 —— L
P3 —— H
P4 —— L

FIG. 5C

P1 —— H
P2 —— H
P3 —— L
P4 —— L

FIG. 5D

P1 —— H
P2 —— L
P3 —— H
P4 —— L

## FIG. 6

## FIG. 7

```
START
  |
S1  SET IMAGE ACQUISITION
    CONDITIONS
  |
S2  ASSIGN MEMORY AREAS TO
    DRIVE CONDITIONS
  |
S3  SET A SEQUENCE OF TIMINGS
    OF RADIATION PULSES
    RELATIVE TO TRIGGER
  |
S4  START IMAGE DATA
    ACQUISION
  |
S5  ACQUISITION COMPLETED?
    NO → (back to S2)
    YES
```

FIG. 8

EP 0 652 444 A1

FIG. 9

FIG. 10

P1

P2

P3

$T_0$  $T_0+\Delta t$  $T_0+3\Delta t$  $T_1=T_0+(N-1)\Delta T$

$T_0+2\Delta t$

FIG.11A

FIG.11B

FIG.11C

FIG.11D

FIG.11E

FIG. 12A

FIG. 12B

FIG. 12C

FIG. 13

28

FIG. 14

FIG. 15

PATTERN
SEQUENCE

A    #r                                    #r

B    Tr                                    Tr

    ΔT                                    ΔT

C    T₀              T₁                    T₀

D    Trd
    T₀
    T₀+Δt  T₀+2Δt  T₀+3Δt    T₀+(N-1)Δt

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | MICROELECTRONIC ENGINEERING, vol.16, no.1/4, March 1992, AMSTERDAM NL pages 3 - 14 MENZEL 'ELECTRON BEAM TESTING TECHNIQUES' * page 10, paragraph 1 - page 12, paragraph 1 * | 2,3 | G01R31/307 |
| A | DE-A-40 23 387 (SIEMENS)  * the whole document * | 1-3,13, 23,26, 29,30 | |
| A | EP-A-0 528 430 (NEC)  * page 2, line 57 - page 3, line 22; figures 1-4 * | 1-3,13, 20,23, 26,29,30 | |
| A | INT. TEST CONF. 1988 PROC. NEW FRONTIERS IN TESTING, 14 September 1988, WASHINGTON,DC, USA pages 908 - 913 NIJIMA ET AL. 'ELECTRON BEAM TESTER INTEGRATED IN A VLSI TESTER' * page 909, right column - page 910, left column; figure 4 * | 1-3 | TECHNICAL FIELDS SEARCHED (Int.Cl.6)  G01R |
| A | FUJITSU-SCIENTIFIC AND TECHNICAL JOURNAL, vol.26, no.1, 1990, KAWASAKI JP pages 71 - 77 KAWABATA ET AL. 'ELECTRON BEAM TESTER FOR VLSI DIAGNOSIS' | | |

The present search report has been drawn up for all claims

| Place of search | Date of completion of the search | Examiner |
|---|---|---|
| THE HAGUE | 20 February 1995 | Iwansson, K |

EPO FORM 1503 03.82 (P04C01)